# EUROPEAN PATENT SPECIFICATION

(11) **EP 4 227 989 B1**
(45) Date of publication and mention of the grant of the patent: **27.05.2026**
(21) Application number: 22859809.0
(22) Date of filing: 18.02.2022
(51) Int. Cl.: H10W 70/20, H10W 40/00

(54) **MANUFACTURING METHOD OF AN INTERNAL CONNECTION COPPER SHEET OF POWER MODULE**
HERSTELLUNGSVERFAHREN EINER INTERNEN KUPFERVERBINDUNGSFOLIE EINES LEISTUNGSMODULS
PROCÉDÉ DE FABRICATION D'UNE FEUILLE DE CUIVRE DE CONNEXION INTERNE DE MODULE DE PUISSANCE

(30) Priority: 23.08.2021 CN 202110968716
(43) Date of publication of application: 16.08.2023
(73) Proprietor: Wuxi Leapers Semiconductor Co., Ltd., Wuxi, Jiangsu 214072 (CN)
(72) Inventor: LIANG, Xiaoguang, Wuxi, Jiangsu 214072 (CN); HONG, Xu, Wuxi, Jiangsu 214072 (CN); DING, Xuanming, Wuxi, Jiangsu 214072 (CN)
(74) Representative: Novagraaf Group
(86) International application number: PCT/CN2022/076716
(87) International publication number: WO 2023/024450

(56) References cited:
- EP-A1- 3 863 045
- EP-A1- 4 148 778
- CN-A- 101 996 982
- CN-A- 105 765 715
- CN-A- 112 038 245
- CN-A- 112 289 763
- CN-A- 112 289 763
- CN-A- 113 658 934
- JP-A- 2009 231 685
- JP-A- H04 200 881
- US-A1- 2013 329 365
- US-A1- 2016 300 770

## Description

### TECHNICAL FIELD

The present disclosure relates to the technical field of power semiconductor module packaging, and in particular, to a power module and a preparation method thereof.

### BACKGROUND

Power semiconductor devices (such as an insulated gate bipolar transistor (IGBT), a metal-oxide-semiconductor field-effect transistor (MOSFET), silicon carbide (SiC), and gallium nitride (GaN)) are widely applied to power supplies and power electronic converters. Therefore, module packaging is generally used in the case of high power, and a copper sheet technology may be used for internal connection thereof.

The strong conductivity of copper can reduce on-resistance and parasitic inductance. In addition, a contact area between a copper frame and a chip is large, and a coefficient of thermal expansion is 16.9× 10⁻⁶/K, which is much lower than that of a conventional aluminum binding wire, thus enhancing the power cycle life. However, there are production and machining requirements for a hollow design of a copper sheet used for welding, to reduce the total weight and prevent the chip from being crushed during welding or under thermal stress. In addition, under the requirements for flatness control between copper bumps, secondary forming is needed. However, due to the process deviation of radian and requirements for designing multi-directional binding wire positions, great complexity is caused to secondary forming machining, which eventually leads to low unit per hour (UPH) output, rising labor costs, poor yield and impossibility of mass production.

The patent document with the publication number of CN107742790A discloses a quick connection copper sheet for an electronic connector and a connection terminal thereof. The quick connection copper sheet includes a connection copper sheet and a connection terminal, where the connection copper sheet has a symmetrical structure, and includes a clamping portion, a guide portion, and a wiring portion. The clamping portion is composed of a first clamping plate and a second clamping plate, the guide portion is composed of two parallel guide plates, a cross section of the wiring portion is in the shape of a hollow isosceles trapezoid, and the connection terminal is in the shape of a conical frustum. However, this patent still has the disadvantages of low output, rising labor costs, poor yield, and impossibility of mass production. CN112289763A discloses a power semiconductor module which comprises a metal bottom plate, an insulation heat dissipation material layer, a chip, a binding plate, silica gel and a shell. The binding plate comprises a copper plate and a copper strip, the copper plate is connected with the copper strip through welding, the binding plate is used for the circuit connection of all parts, and the metal bottom plate is connected with the insulation heat dissipation material layer through soldering tin. Wherein the chip is connected with the insulation heat dissipation material layer through soldering tin, the chip is connected with the copper strip, and the copper strip is connected with the insulation heat dissipation material layer.

### SUMMARY

In view of the disadvantages in the prior art, an objective of the present disclosure is to provide a preparation method of an internal connection copper sheet of a power module.

The present disclosure provides a preparation method of an internal connection copper sheet of a power module, wherein the internal connection copper sheet includes a copper plate, a first copper strip, and a second copper strip, where the first copper strip and the second copper strip are spaced apart on the copper plate;
the first copper strip and the second copper strip both have an arc-shape with a flat top portion at top; two ends of the first copper strip are arranged on the copper plate, and two ends of the second copper strip are arranged on the copper plate; and
the copper plate is provided with punched holes at positions corresponding to lower portions of the first copper strip and the second copper strip; wherein
the preparation method comprises the following steps:
   step 1: placing the arc-shaped first copper strip and the arc-shaped second copper strip corresponding to the punched holes in the copper plate;
   step 2: connecting the first copper strip and the second copper strip to the copper plate by means of a binding and bonding process;
   step 3: allowing metal strips configured to support the first copper strip and the second copper strip to run through the punched holes and be fixed, to support the first copper strip and the second copper strip; and
   step 4: positioning the copper plate on a forming jig, and press-molding by means of the forming jig in conjunction with the metal strips to form the flat top portion at top of each of the first copper strip and the second copper strip; and removing the forming jig and metal strips.

Preferably, the first copper strip and the second copper strip are integrally formed.

Preferably, the copper plate is hollow.

Preferably, the first copper strip has a width of 2000 µm and a thickness of 200 µm.

Preferably, the second copper strip has a width of 2000 µm and a thickness of 200 µm.

Compared with the prior art, the present disclosure has following beneficial effects:
1. According to the present disclosure, the weight of the copper plate used for internal electrical connection is reduced, thereby reducing the fracturing of a chip caused by a mechanical force when the copper plate is welded to the chip.
2. According to the present disclosure, the machining process complexity during secondary forming of the bound copper plate is reduced. The yield is increased by about 10 times, and the forming yield is increased by about 10%.
3. According to the present disclosure, the difficulty of secondary forming of the copper plate in the module is reduced, and the mass production capacity is implemented.

### BRIEF DESCRIPTION OF THE DRAWINGS

Other features, objectives, and advantages of the present disclosure will become more apparent by reading the detailed description of non-limiting embodiments with reference to the following accompanying drawings.
FIG. 1 is a schematic structural diagram of an internal connection copper sheet of a power module according to Embodiment 1 of the present disclosure (not constituting a part of the invention);
FIG. 2 is a schematic machining diagram of an internal connection copper sheet of a power module according to Embodiment 1 of the present disclosure (not constituting a part of the invention);
FIG. 3 is a schematic installation diagram of an internal connection copper sheet of a power module according to Embodiment 1 of the present disclosure (not constituting a part of the invention);
FIG. 4 is a schematic structural diagram of an internal connection copper sheet of a power module according to Embodiment 2 of the present disclosure;
FIG. 5 is a schematic machining diagram of an internal connection copper sheet of a power module according to Embodiment 2 of the present disclosure;
FIG. 6 is a schematic installation diagram of an internal connection copper sheet of a power module according to Embodiment 2 of the present disclosure; and
FIG. 7 is a schematic machining diagram of an internal connection copper sheet of a power module according to Embodiment 3 of the present disclosure (not constituting a part of the invention).

### Reference numerals:

| | |
|---|---|
| Copper plate 1 | Punched hole 4 |
| First copper strip 2 | Metal strip 5 |
| Second copper strip 3 | |

### DETAILED DESCRIPTION OF THE EMBODIMENTS

The present disclosure is described in detail below with reference to specific embodiments. The following embodiments will help a person skilled in the art further understand the present disclosure, but will not limit the present disclosure in any way. It should be noted that several variations and improvements can also be made by a person of ordinary skill in the art without departing from the conception of the present disclosure. These all fall within the protection scope of the present disclosure.

### Embodiment 1 (not constituting a part of the invention)

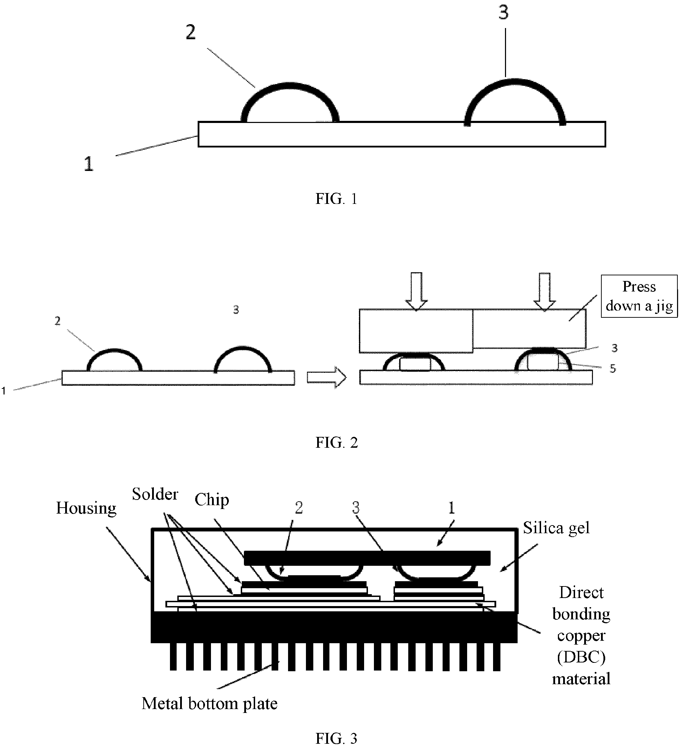

As shown in FIGS. 1 to 3, an internal connection copper sheet of a power module according to the present disclosure includes copper plate 1, first copper strip 2, and second copper strip 3, where the first copper strip 2 and the second copper strip 3 are spaced apart on the copper plate 1; the first copper strip 2 and the second copper strip 3 are both arc-shaped; two ends of the first copper strip 2 are arranged on the copper plate 1, and two ends of the second copper strip 3 are arranged on the copper plate 1. The copper plate 1 is hollow. The first copper strip 2 has a width of 2000 µm and a thickness of 200 µm. The second copper strip 3 has a width of 2000 µm and a thickness of 200 µm.

The present disclosure further provides a preparation method of the internal connection copper sheet of a power module described above, including the following steps.

Step 1: Arc-shaped first copper strip 2 and arc-shaped second copper strip 3 are connected to copper plate 1 by means of a binding and bonding process.

Step 2: Corresponding metal strips 5 are inserted from side surfaces of the first copper strip 2 and the second copper strip 3 respectively to support the first copper strip 2 and the second copper strip 3.

Step 3: The copper plate 1 is positioned on a forming jig, and press-molding is performed by means of the forming jig.

According to this embodiment, the difficulty of secondary forming of the copper plate in the module is reduced, and the mass production capacity is implemented.

In a preferred example, on a solid copper plate, copper strips with a width of 2000 µm and a thickness of 200 µm are connected to the copper plate by using a binding and bonding process, the copper strips are arc-shaped, then corresponding metal strips are inserted from side surfaces of wire arcs respectively to support the wire arcs, and finally the internal connection copper sheet of a power module is formed through pressing by a forming jig with a specific height, as shown in FIGS. 1 and 2. The formed copper plate is connected to a surface of a chip through welding, as shown in FIG. 3.

### Embodiment 2

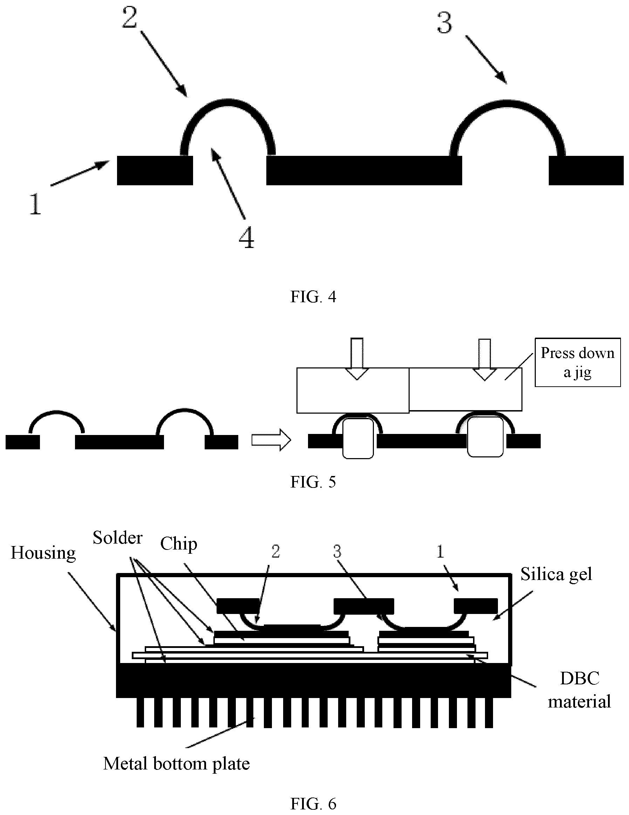

As shown in FIGS. 4 to 6, this embodiment differs from Embodiment 1 in that the copper plate 1 is provided with punched holes 4 at positions corresponding to lower portions of the first copper strip 2 and the second copper strip 3.

The present disclosure further provides a preparation method of the internal connection copper sheet of a power module described above, including the following steps.

Step 1: Arc-shaped first copper strip 2 and arc-shaped second copper strip 3 are placed corresponding to punched holes 4 in a copper plate 1.

Step 2: The first copper strip 2 and the second copper strip 3 are connected to the copper plate 1 by means of a binding and bonding process.

Step 3: Metal strips 5 configured to support the first copper strip 2 and the second copper strip 3 run through the punched holes 4 and are fixed, to support the first copper strip 2 and the second copper strip 3.

Step 4: The copper plate 1 is positioned on a forming jig, and press-molding is performed by means of the forming jig.

In this embodiment, the raw material copper plate under a binding ribbon is hollowed out, the design is performed in consideration of requirements of punching on the opening and thickness of the copper plate, and the secondary forming is implemented by one-time insertion in a jig base and machining instead of multi-times lateral-orientation insertion and machining.

In a preferred example, a corresponding solid copper plate below wire arcs is subjected to opening design and machining, and then copper strips with a width of 2000 µm and a thickness of 200 µm are connected to the copper plate by using a binding and bonding process, the copper strips are arc-shaped, metal strips configured to support the wire arcs are extended out from below a jig and fixed in one time, and then the perforated copper plate to which a binding wire is welded is positioned on the forming jig, so that the continuous press molding operation can be performed, as shown in FIGS. 4 and 5. The formed copper plate is connected to a surface of a chip through welding, as shown in FIG. 6.

### Embodiment 3 (not constituting a part of the invention)

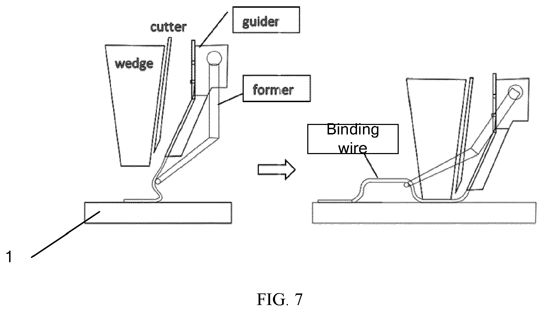

As shown in FIGS. 3 and 7, this embodiment differs from Embodiment 1 in that the first copper strip 2 and the second copper strip 3 are integrally formed.

The present disclosure further provides a preparation method of the internal connection copper sheet of a power module described above, including the following steps.

Step 1: A looper is added on a welding head.

Step 2: Copper strips are bound to a copper plate 1.

Step 3: Wire arc drawing is performed on the copper strips to form a final platform shape in one time.

In this embodiment, during welding of a binding wire or a ribbon to the copper plate, loop forming is added by a welding wire device for one-time forming without secondary forming machining.

In a preferred embodiment, during welding of the binding wire or the ribbon to the copper plate, a loop former is added by a welding head of the welding wire device, and one-time forming is implemented during binding and wire arc drawing to obtain a final platform shape, as shown in FIG. 7. The copper plate is connected to a surface of a chip through welding, as shown in FIG. 3.

The present disclosure further provides a power semiconductor module, including the internal connection copper sheet of a power module described above.

According to the present disclosure, the weight of the copper plate used for internal electrical connection is reduced, thereby reducing the fracturing of a chip caused by a mechanical force when the copper plate is welded to the chip. According to the present disclosure, the machining process complexity during secondary forming of the bound copper plate is reduced, the yield is increased by about 10 times, and the forming yield is increased by about 10%.

In the description of the present application, it needs to be understood the orientation or positional relationships indicated by terms, such as "up", "down", "front", "rear", "left", "right", "vertical", "horizontal", "top", "bottom", "inside", and "outside", are based on the orientation or positional relationship shown in the accompanying drawings, are merely for facilitating the description of the present application and simplifying the description, rather than indicating or implying that an apparatus or element referred to must have a particular orientation or be constructed and operated in a particular orientation, and therefore shall not be interpreted as limiting the present application.

The specific embodiments of the present disclosure are described above. It should be understood that the present disclosure is not limited to the above specific implementations, and a person skilled in the art can make various variations or modifications within the scope of the claims without affecting the essence of the present disclosure. The embodiments of the present disclosure and features in the embodiments may be arbitrarily combined with each other in the case of no conflict.

## Claims

1. A preparation method of an internal connection copper sheet of a power module, wherein the internal connection copper sheet comprises a copper plate (1), a first copper strip (2), and a second copper strip (3), wherein the first copper strip (2) and the second copper strip (3) are spaced apart on the copper plate (1);
two ends of the first copper strip (2) are arranged on the copper plate (1), and two ends of the second copper strip (3) are arranged on the copper plate (1);
the first copper strip (2) and the second copper strip (3) both have an arc-shape with a flat top portion at top; and
the copper plate (1) is provided with punched holes (4) at positions corresponding to lower portions of the first copper strip (2) and the second copper strip (3);
wherein the preparation method comprises the following steps:
step 1: placing the arc-shaped first copper strip (2) and the arc-shaped second copper strip (3) corresponding to the punched holes (4) in the copper plate (1);
step 2: connecting the first copper strip (2) and the second copper strip (3) to the copper plate (1) by means of a binding and bonding process;
step 3: allowing metal strips (5) configured to support the first copper strip (2) and the second copper strip (3) to run through the punched holes (4) and be fixed, to support the first copper strip (2) and the second copper strip (3); and
step 4: positioning the copper plate (1) on a forming jig, and press-molding by means of the forming jig in conjunction with the metal strips (5) to form the flat top portion at top of each of the first copper strip (2) and the second copper strip (3); and removing the forming jig and metal strips.

2. The preparation method of the internal connection copper sheet of the power module according to claim 1, wherein the first copper strip (2) and the second copper strip (3) are integrally formed.

3. The preparation method of the internal connection copper sheet of the power module according to claim 1, wherein the copper plate (1) is hollow.

4. The preparation method of the internal connection copper sheet of the power module according to claim 1, wherein the first copper strip (2) has a width of 2000 µm and a thickness of 200 µm.

5. The preparation method of the internal connection copper sheet of the power module according to claim 1, wherein the second copper strip (3) has a width of 2000 µm and a thickness of 200 µm.

## Patentansprüche

1. Herstellungsverfahren eines Kupferblechs für eine interne Verbindung eines Leistungsmoduls, wobei das Kupferblech für die interne Verbindung eine Kupferplatte (1), einen ersten Kupferstreifen (2) und einen zweiten Kupferstreifen (3) umfasst, wobei der erste Kupferstreifen (2) und der zweite Kupferstreifen (3) auf der Kupferplatte (1) beabstandet sind;
zwei Enden des ersten Kupferstreifens (2) auf der Kupferplatte (1) angeordnet sind und zwei Enden des zweiten Kupferstreifens (3) auf der Kupferplatte (1) angeordnet sind;
der erste Kupferstreifen (2) und der zweite Kupferstreifen (3) beide eine Bogenform mit einem flachen oberen Abschnitt an einer Oberseite aufweisen; und
die Kupferplatte (1) mit gestanzten Löchern (4) an Positionen entsprechend unteren Abschnitten des ersten Kupferstreifens (2) und des zweiten Kupferstreifens (3) bereitgestellt ist;
wobei das Herstellungsverfahren die folgenden Schritte umfasst:
Schritt 1: Platzieren des bogenförmigen ersten Kupferstreifens (2) und des bogenförmigen zweiten Kupferstreifens (3) entsprechend den gestanzten Löchern (4) in der Kupferplatte (1);
Schritt 2: Verbinden des ersten Kupferstreifens (2) und des zweiten Kupferstreifens (3) mit der Kupferplatte (1) mittels eines Binde- und Bondprozesses;
Schritt 3: Ermöglichen, dass Metallstreifen (5), die konfiguriert sind, um den ersten Kupferstreifen (2) und den zweiten Kupferstreifen (3) zu stützen, durch die gestanzten Löcher (4) hindurch verlaufen und befestigt werden, um den ersten Kupferstreifen (2) und den zweiten Kupferstreifen (3) zu stützen; und
Schritt 4: Positionieren der Kupferplatte (1) auf einer Ausbildungsvorrichtung und Pressformen mittels der Ausbildungsvorrichtung gemeinsam mit den Metallstreifen (5), um den flachen oberen Abschnitt an der Oberseite jedes des ersten Kupferstreifens (2) und des zweiten Kupferstreifens (3) auszubilden; und Entfernen der Ausbildungsvorrichtung und der Metallstreifen.

2. Herstellungsverfahren des Kupferblechs für die interne Verbindung des Leistungsmoduls nach Anspruch 1, wobei der erste Kupferstreifen (2) und der zweite Kupferstreifen (3) einstückig ausgebildet sind.

3. Herstellungsverfahren des Kupferblechs für die interne Verbindung des Leistungsmoduls nach Anspruch 1, wobei die Kupferplatte (1) hohl ist.

4. Herstellungsverfahren des Kupferblechs für die interne Verbindung des Leistungsmoduls nach Anspruch 1, wobei der erste Kupferstreifen (2) eine Breite von 2000 µm und eine Dicke von 200 µm aufweist.

5. Herstellungsverfahren des Kupferblechs für die interne Verbindung des Leistungsmoduls nach Anspruch 1, wobei der zweite Kupferstreifen (3) eine Breite von 2000 µm und eine Dicke von 200 µm aufweist.

## Revendications

1. Procédé de préparation d'une feuille de cuivre de connexion interne d'un module de puissance, dans lequel la feuille de cuivre de connexion interne comprend une plaque de cuivre (1), une première bande de cuivre (2) et une seconde bande de cuivre (3), dans lequel la première bande de cuivre (2) et la seconde bande de cuivre (3) sont espacées sur la plaque de cuivre (1) ;
deux extrémités de la première bande de cuivre (2) sont disposées sur la plaque de cuivre (1), et deux extrémités de la seconde bande de cuivre (3) sont disposées sur la plaque de cuivre (1) ;
la première bande de cuivre (2) et la seconde bande de cuivre (3) ont toutes deux une forme d'arc avec une partie supérieure plate au niveau d'un sommet ; et
la plaque de cuivre (1) est pourvue de trous perforés (4) au niveau de positions correspondant à des parties inférieures de la première bande de cuivre (2) et de la seconde bande de cuivre (3) ;
dans lequel le procédé de préparation comprend les étapes suivantes consistant à :
étape 1 : mettre la première bande de cuivre (2) en forme d'arc et la seconde bande de cuivre (3) en forme d'arc en correspondance avec les trous perforés (4) dans la plaque de cuivre (1) ;
étape 2 : relier la première bande de cuivre (2) et la seconde bande de cuivre (3) à la plaque de cuivre (1) au moyen d'un processus de liaison et de collage ;
étape 3 : permettre à des bandes métalliques (5) conçues pour soutenir la première bande de cuivre (2) et la seconde bande de cuivre (3) de passer à travers les trous perforés (4) et d'être fixées, afin de soutenir la première bande de cuivre (2) et la seconde bande de cuivre (3) ; et
étape 4 : positionner la plaque de cuivre (1) sur un gabarit de formage, et mouler à la presse au moyen du gabarit de formage en conjonction avec les bandes métalliques (5) afin de former la partie supérieure plate au niveau du sommet de chacune de la première bande de cuivre (2) et de la seconde bande de cuivre (3) ; et retirer le gabarit de formage et les bandes métalliques.

2. Procédé de préparation de la feuille de cuivre de connexion interne du module de puissance selon la revendication 1, dans lequel la première bande de cuivre (2) et la seconde bande de cuivre (3) sont formées d'un seul tenant.

3. Procédé de préparation de la feuille de cuivre de connexion interne du module de puissance selon la revendication 1, dans lequel la plaque de cuivre (1) est creuse.

4. Procédé de préparation de la feuille de cuivre de connexion interne du module de puissance selon la revendication 1, dans lequel la première bande de cuivre (2) a une largeur de 2 000 µm et une épaisseur de 200 µm.

5. Procédé de préparation de la feuille de cuivre de connexion interne du module de puissance selon la revendication 1, dans lequel la seconde bande de cuivre (3) a une largeur de 2 000 µm et une épaisseur de 200 µm.
